Europäisches Patentamt

European Patent Office

Office européen des brevets

(11) Veröffentlichungsnummer: **0 356 438 B1**

## (12) EUROPÄISCHE PATENTSCHRIFT

(45) Veröffentlichungstag der Patentschrift: **10.02.93**

(21) Anmeldenummer: **88902806.4**

(22) Anmeldetag: **31.03.88**

(86) Internationale Anmeldenummer:
**PCT/DE88/00210**

(87) Internationale Veröffentlichungsnummer:
**WO 88/07658 (06.10.88 88/22)**

Die Akte enthält technische Angaben, die nach
dem Eingang der Anmeldung eingereicht wurden
und die nicht in dieser Patentschrift enthalten sind.

(51) Int. Cl.⁵: **H03M 1/52**, G01D 3/04,
G01R 17/06

---

### (54) VERFAHREN UND ANORDNUNG ZUR AUSWERTUNG EINER ANALOGEN ELEKTRISCHEN MESSGRÖSSE.

---

(30) Priorität: **01.04.87 DE 3710904**

(43) Veröffentlichungstag der Anmeldung:
**07.03.90 Patentblatt 90/10**

(45) Bekanntmachung des Hinweises auf die
Patenterteilung:
**10.02.93 Patentblatt 93/06**

(84) Benannte Vertragsstaaten:
**AT BE CH DE FR GB IT LI LU NL SE**

(56) Entgegenhaltungen:
**DE-A- 3 330 841**
**US-A- 3 631 467**

(73) Patentinhaber: **SIEMENS AKTIENGESELL-
SCHAFT**
**Wittelsbacherplatz 2**
**W-8000 München 2(DE)**

(72) Erfinder: **HORN, Klaus**
**Sanddornweg 10a**
**W-3300 Braunschweig(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf ein Verfahren und eine Anordnung zur Analog-Digital-Umsetzung eines elektrischen Meßsignals nach dem Zeitteilerprinzip gemäß den Merkmalen des Oberbegriffs des Anspruchs 1 und des Anspruchs 2.

Bei meßwertverarbeitenden Systemen, die das Zeitteilerprinzip benutzen, werden Auswertverfahren angewandt, bei denen in einem festgelegten Integrationszeitraum den Meßgrößen äquivalente Werte, beispielsweise durch Auszählung von Taktimpulsen konstanter Frequenz, ermittelt werden; es wird somit eine entsprechende Analog-Digital-Umsetzung durchgeführt. Das Zeitteilerprinzip enthält zwei Integrationsteile, von denen der erste Teil eine Kompensierung der Meßgröße mit einer Verstimmungsgröße entgegengesetzter Polarität darstellt (Aufintegration) und der zweite Integrationsteil eine Abintegration der Meßgröße enthält. Damit am Ende der beiden Integrationsteile, also am Ende der Zeitteilerperiode, das Integrationssignal zu Null geworden ist, muß die Zeit des ersten Integrationsteils im Verhältnis zur gesamten Zeitteilerperiode entsprechend eingestellt werden. Somit kann aus diesem Zeitteilertaktverhältnis direkt das Meßergebnis entnommen werden.

Aus der US-PS 3 631 467 ist ein Analog-Digital-Umsetzer bekannt, der ein analoges Eingangssignal in zwei Umsetzzyklen in seine Digitaldarstellung wandelt. Im ersten Umsetzzyklus wird zunächst für ein erstes Zeitintervall das unbekannte analoge Eingangssignal an einen Integrator angelegt. Danach wird ein Referenzsignal aufintegriert und durch Zählen von Impulsen die Zeit gemessen, in welcher das Ausgangssignal des Integrators einen Referenzpegel erreicht. Aufgrund dieser gemessenen Zeit wird das Zeitteilertaktverhältnis für den zweiten Umsetzzyklus bestimmt. Im ersten Zeitabschnitt der Zeitteilerperiode, also während des Zeitteilertaktes, werden beide Signale auf den Integrator geschaltet und während des zweiten Zeitabschnitts lediglich das analoge Eingangssignal. Nach Ablauf der Zeitteilerperiode wird in der Abweichungsverschlüsselungsphase das Vergleichssignal an den Integrator gelegt und die Zeit gemessen, in der das Ausgangssignal des Integrators wieder einen Referenzpegel erreicht. Aus den im ersten und zweiten Umsetzzyklus gemessenen Zeiten wird der Digitalwert des analogen Eingangssignals ermittelt. Diese Art der Analog-Digital-Umsetzung hat den Nachteil, daß immer zwei Umsetzzyklen erforderlich sind, um einen Digitalwert zu bestimmen.

Bei einem weiteren bekannten, nach dem Zeitteilerprinzip arbeitenden Verfahren dieser Art (DE-PS 33 30 841) konnten bei vergleichsweise geringem Bauteileaufwand hohe Auflösungen und Umsetzgenauigkeiten erzielt werden. Die verwendete Integrationsschaltung zur Analog-Digital-Umsetzung weist jedoch einige Nachteile auf; denn bei ihr wird das Zeitteilertaktverhältnis, d. h. die richtige Einstellung der Zeit des ersten Integrationsteils im Verhältnis zur gesamten Zeitteilerperiode, durch eine sich über eine Vielzahl von Zeitteilerperioden erstreckende Auswertung des verstärkten Regelabweichungssignales sowie über dessen phasenselektive Gleichrichtung und nachfolgende Glättung durch ein analoges, in einen Nachlaufregelkreis der Zeitteilereinstellung einbezogenes Tiefpaßfilter gewonnen. Dadurch weist das bekannte Verfahren aber ein recht träges Ansprechverhalten gegenüber sprungförmigen Änderungen der Meßgröße auf. Hier sind je nach Auflösung Totzeiten und/oder Einstellzeiten $t_e$ von ~ 100 ms < $t_e$ < I s typisch, die bei einer Vielzahl von Anwendungen den praktischen Einsatz von Zeitteilerschaltungen bisher zumindest problematisch, wenn nicht gar unmöglich machten.

Der Erfindung liegt die Aufgabe zugrunde, ein Verfahren und eine Anordnung zu schaffen, die unter Beibehaltung des geringen Aufwandes und der hohen Genauigkeit und Langzeitstabilität des Zeitteilerprinzips eine erhebliche Verbesserung im Ansprechverhalten der digitalen Meßwerte nach sprunghaften Änderungen der Meßgröße sowie in deren Auswertung und Weiterverarbeitung ermöglicht.

Zur Lösung dieser Aufgabe weist das Verfahren der eingangs genannten Art die Merkmale des Kennzeichens des Anspruchs 1 auf.

Das erfindungsgemäße Verfahren wird vorteilhaft in der Weise ausgeführt, daß zunächst in einem ersten Schritt die Regelabweichung $\Delta\alpha_i$ vom richtigen Zeitteilertaktverhältnis durch bestimmte Integration über das Meß- und Vergleichssignal - z. B. durch einen Miller-Integrator - jeweils exakt über eine volle Zeitteilerperiode T bestimmt wird. Ein dabei gewonnenes analoges Integrationssignal $\Delta U_i$ dient als Maß für die Regelabweichung, das nach dem Ende der Zeitteilerperiode von einem schnellen Analog-Digital-Umsetzer - z. B. einem Sägezahnverschlüßler - in der Abweichungsverschlüsselungsphase in ein digitales Regelabweichungssignal $m_I$ umgesetzt und zur Korrektur des Zeitteilertaktverhältnisses

$$\alpha_2 = \frac{n_2}{N} = \frac{n_1 + m_1}{N}$$

in der nachfolgenden zweiten Zeitteilerperiode herangezogen wird.

Der Gesamtschaltungsaufwand läßt sich dann besonders klein halten, wenn der verwendete Integrator, z. B. der Miller-Integrator, nach Art eines Dual-Slope-Verfahrens doppelt genutzt wird, indem alternierend in einem ersten Schritt zunächst über die Zeitteilerperiode $T_1$ die Summe aus Meßsignal (Eingangsspannung $U_m$) und Vergleichssignal (Normalspannung $U_N$) aufintegriert und anschließend das dabei gewonnene Abweichungssignal durch zählende Abwärtsintegration digitalisiert wird. Das an und für sich bekannte Dual-Slope-Verfahren für eine schnelle Analog-Digital-Umsetzung ist beispielsweise in Tietze/Schenk "Halbleiterschaltungstechnik", 5. Auflage, 1980, Springer-Verlag, Seiten 663, 664 beschrieben.

Weiterhin kann diese Abwärtsintegration aus Geschwindigkeits- und Aufwandsgründen zweckmäßig kaskadiert erfolgen. Bekannt ist eine derartige Kaskadierung an sich aus Angersbach F. "Über die Genauigkeit elektrischer Grundnormale und Kompensationsmeßeinrichtungen", ATM (1964) T 930-3.

Eine vorteilhafte Lösung der gestellten Aufgabe ist auch mit einer Anordnung zur Durchführung des Verfahrens der vorhergehend angegebenen Art gegeben, welche die Merkmale des Anspruchs 2 aufweist. Eine Anordnung mit einem integrierenden Nullverstärker, an dessen Eingängen über Schalter - im Zeitteilertaktverhältnis gesteuert - die Vergleichsgröße und/oder die Meßgröße anliegen, ist aus der bereits eingangs genannten DE-PS 33 30 841 bekannt. Gemäß der Erfindung wird durch die angegebene Ausbildung der Steuereinheit die Durchführung der Abweichungsverschlüsselungsphase mit einer Auswertung des Regelabweichungssignals in vorteilhafter Weise möglich gemacht.

Entsprechend einer weiteren Ausbildung der Erfindung nach Anspruch 3 wird zur Steuerung der Zeitteilerperioden $T_\nu$, seines Zeitteilertaktverhältnisses $\alpha_\nu = n_\nu / N$ sowie der Umschaltungen des Integrationsverstärkers zweckmäßig ein Mikrocomputer eingesetzt, dem auch die Aufgabe der Unterdrückung dynamischer Störkomponenten und von Rauschanteilen im Meßsignal durch digitale Filterung der in schneller Folge anfallenden Meßwerte $n_\nu + m_\nu = n_{\nu+1}$ gemäß Anspruch 5 übertragen werden kann. Da diese Digitalfilterung bei der erfindungsgemäßen Anordnung nicht mehr im Regelkreis der Zeitteileranordnung liegt, kann sie nach jedem zweckmäßigen Filteralgorithmus arbeiten, ohne Stabilitätsprobleme im Nachlaufregelkreis in Kauf nehmen zu müssen.

Entsprechend einem weiteren Ausführungsbeispiel nach Anspruch 4 kann vorteilhaft auch bei hohen Genauigkeitsanforderungen die in der eingangs erwähnten DE-PS 33 30 841 beschriebene Polwechselung zur Unterdrückung sowohl von Störungen durch Thermo- und Kontaktspannungen im Meßkreis als auch von Nulldriften und Rauschkomponenten des integrierenden Nullverstärkers vorteilhaft genutzt werden, wenn der Mikroprozessor die angelieferten Digitalsignale entsprechend der alternierenden Polung mit synchron wechselnden Vorzeichen bewertet. Aus der Folge der dann mit abwechselnden Vorzeichen gewonnenen Meßwerte kann so vom Mikroprozessor Größe und Vorzeichen einer Gleichspannungsdrift erkannt und bei der Berechnung der Zeitteilereinstellwerte berücksichtigt werden. Vor allem kann nach Anspruch 7 bei hohen Genauigkeitsanforderungen eine analoge Kompensation der Nulldrift aufgeschaltet werden, so daß der Nullverstärker vor Übersteuerungen bewahrt und immer in seinem symmetrischen Arbeitspunkt betrieben wird.

Eine besonders vorteilhafte Anwendung des erfindungsgemäßen Verfahrens und der erfindungsgemäßen Anordnung ergibt sich, wenn mit den Merkmalen des Anspruchs 8 die Erfindung bei hochgenauen elektromechanischen Waagen benutzt wird, die eine schnelle Anzeige des gemessenen Wertes auch bei schnellem Lastwechsel gewährleisten soll.

Die Erfindung wird anhand der Figuren erläutert, wobei

Figur 1 ein erstes Ausführungsbeispiel der Ausführung des Verfahrens zeigt, an dem die prinzipielle Wirkungsweise eines Meßverfahrens mit dem Zeitteilerprinzip erkennbar ist,

Figur 2 die zum Verständnis des Ausführungsbeispiels notwendigen Signal- und Schalterdiagramme,

Figur 3 ein erweitertes Ausführungsbeispiel mit einem Meßgrößenaufnehmer in Brückenschaltung,

Figur 4 die zum Verständnis des erweiterten Ausführungsbeispiels notwendigen Signal- und Schalterdiagramme,

Figur 5 ein drittes Ausführungsbeispiel mit einem Dual-Slope-Analog-Digital-Umsetzer und einer Kaskadierung des Abintegrationsvorgangs,

Figur 6 eine Variante des Ausführungsbeispiels nach Figur 5 mit einer erdsymmetrischen Betriebsweise des Meßgrößenaufnehmers,

Figur 7 ein viertes Ausführungsbeispiel mit einer Polumschaltung der Gleichstrom- bzw. Gleichspannungsversorgung des Meßgrößenaufnehmers und

Figur 8 ein zum Verständnis des vierten Ausführungsbeispiels notwendiges Signal- und Schalterdiagramm darstellt.

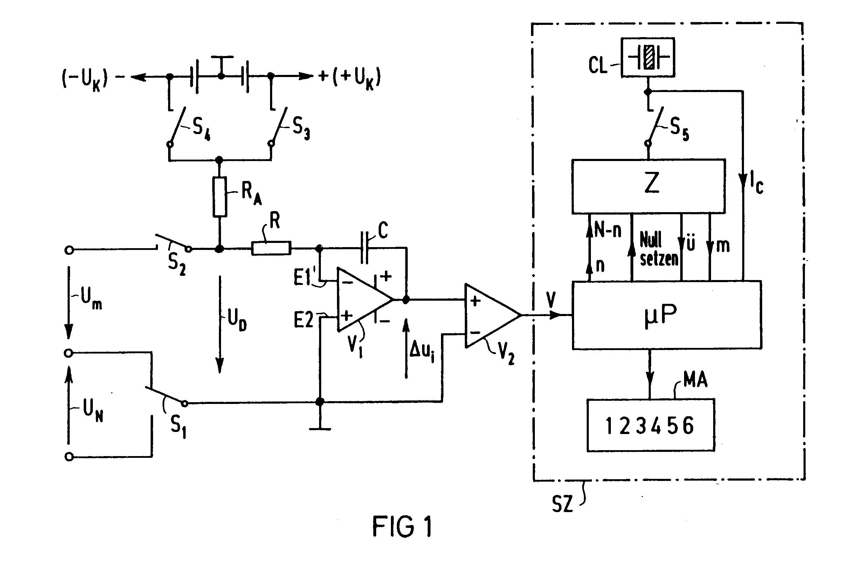

Bei der in der Figur 1 gezeigten Schaltung sind eine Eingangsspannung $U_m$ als analoge elektrische Meßgröße und eine Normalspannung $U_N$ als Vergleichs- oder Referenzgröße vorhanden, die über einen

Schalter $S_2$ und einen Widerstand R an einen ersten Eingang $E_1$ eines ersten Operationsverstärkers $V_1$ und über einen Umschalter $S_1$ an einen zweiten Eingang $E_2$ des Operationsverstärkers $V_1$ geführt sind. Der zweite Eingang $E_2$ befindet sich auf Massepotential. Der Operationsverstärker $V_1$ stellt mit dem Widerstand R und einem Kondensator C einen Miller-Integrator zur bestimmten Integration einer Spannung $U_D$ dar, die aus der Eingangsspannung $U_m$ und/oder der Normalspannung $U_N$ gebildet ist. Am Ausgang des Operationsverstärkers $V_1$ liegt eine Spannung $\Delta U_i$ an, die im Falle der Einstellung eines richtigen Zeitteilertaktverhältnisses $\alpha$ am Ende der sich über eine volle Zeitteilerperiode T erstreckenden Integration von $U_D$ gleich Null ist, aber beim Vorliegen eines fehlerhaften Zeitteilertaktverhältnisses $\alpha$ einen Wert aufweist, der nach Vorzeichen und Betrag proportional zur Abweichung $\Delta\alpha$ des Zeitteilertaktverhältnisses $\alpha$ von seinem richtigen Wert

$$\alpha_{richtig} = \frac{U_M}{U_N} = \frac{\tau_{richtig}}{T} \qquad (1)$$

ist.

An einem Schaltungspunkt zwischen dem Schalter $S_2$ und dem Widerstand R ist über einen Widerstand $R_A$ entweder eine positive Kompensationsspannung $+U_K$ über einen Schalter $S_3$ oder eine negative Kompensationsspannung $-U_K$ über einen Schalter $S_4$ anlegbar, die auf den ersten Eingang $E_1$ des Operationsverstärkers $V_1$ wirkt. Dabei kann der Widerstand $R_A$ entfallen (d. h. $R_A = 0$), wenn $U_K$ so dimensioniert wird, daß die Gleichung $|U_K| = U_N$ erfüllt ist.

Die Spannung $\Delta U_i$ am Ausgang des Operationsverstärkers $V_1$ ist auf einen Eingang eines als Komparator geschalteten zweiten Operationsverstärkers $V_2$ geführt. Die Komparatorausgangsgröße V steht als binäre Größe am Eingang einer Steuer- und Zählschaltung SZ an und gibt Auskunft über das Vorzeichen von $\Delta U_i$. Diese Steuer- und Zählschaltung SZ weist als wesentlichen Bestandteil einen Mikroprozessor $\mu$P auf, der von einem Taktgenerator CL mit Taktimpulsen $I_c$ versorgt ist. Weiterhin ist entsprechend einer in der DE-PS 33 30 841 näher beschriebenen Methode ein setzbarer Abwärtszähler Z vorhanden, der einerseits über einen Schalter $S_5$ mit den Taktimpulsen des Taktgenerators CL versorgbar ist und weiterhin Setzinformationen n vom Mikroprozessor $\mu$P erhält. Wird der Zähler von den Taktimpulsen $I_c$ des Taktgenerators CL auf den Inhalt Null herabgezählt, liefert er einen Steuerimpuls an den Mikroprozessor $\mu$P. Der Mikroprozessor $\mu$P liefert auch Steuerimpulse für die Schalter $S_1 \ldots S_4$ über hier nicht näher dargestellte Steuerleitungen. Die Anzeige eines der Meßgröße äquivalenten numerischen Wertes wird mittels einer Anzeigeeinheit MA vorgenommen. Der Mikroprozessor setzt dabei den Zähler Z zum Beginn einer bestimmten Integrationsperiode auf einen Wert $n = \alpha \cdot N$. Nach dem Einzählen von n Taktimpulsen mit der Taktperiodendauer $T_c$ ist genau die Dauer des Zeitteilertaktes $\tau = n \cdot T_c$ vergangen, wenn der Zähler einen ersten Null-Impuls abgibt. Dieser schaltet die Vergleichsgröße $(U_V)$ ab und setzt gleichzeitig den Zähler auf den Wert $\bar{n} = N - n$. Wenn der Zähler dann erneut auf Null herabgezählt ist, beendet der erneute Null-Impuls die bestimmte Integration über eine volle Zeitteilerperiode $T = N \cdot T_c$, bei dem das Zeitteilertaktverhältnis

$$\alpha = \frac{\tau}{T} = \frac{n \cdot T_c}{N \cdot T_c} = \frac{n}{N} \qquad (2)$$

geschaltet wurde.

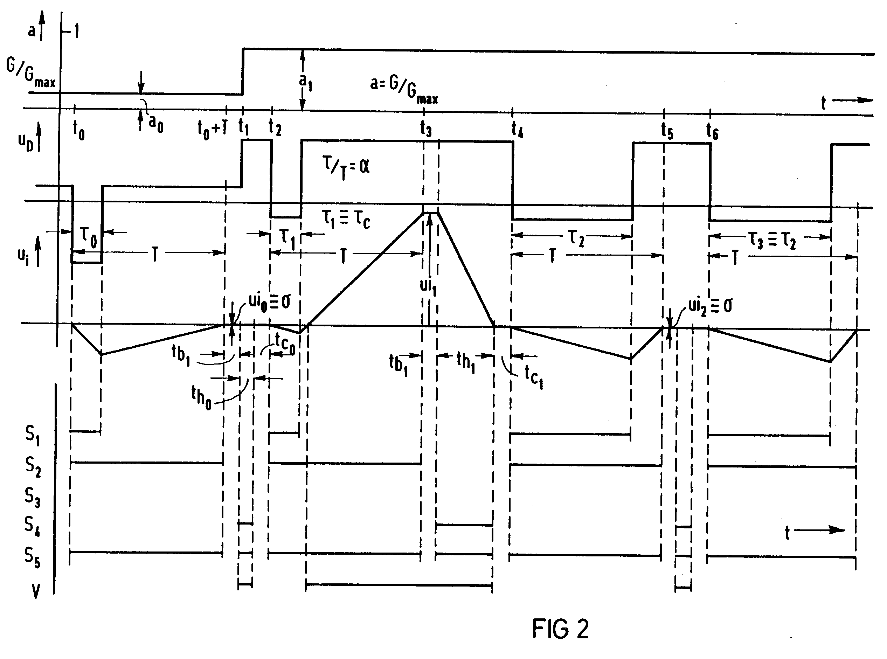

Die Schaltung aus der Figur 1 wird unter Zuhilfenahme der Diagramme der Figur 2 erläutert. Das oberste Diagramm gibt den Aussteuerungsfaktor

$$a = \frac{G}{G_{max}}$$

über der Zeit t wieder, der bis zum Zeitpunkt $t_1$ den Wert $a_0$ und ab dem Zeitpunkt $t_1$ den Wert $a_1$ aufweist. Darunter ist der Verlauf der Spannung $U_D$ am Eingang des Operationsverstärkers $V_1$ angegeben, aus der das Zeitteilertaktverhältnis

$$\alpha_0 = \frac{\tau_0}{T} = \alpha_0$$

erkennbar ist. Als drittes Spannungsdiagramm ist der Verlauf der Spannung $U_i$ dargestellt, aus dem die Integrationsvorgänge, hervorgerufen durch die Zeitteilertakte $\tau$ oder durch die Schaltvorgänge in den Abweichungsverschlüsselungsphasen AV, ersichtlich sind. Darunter sind noch die Schaltzustände der Schalter $S_1$, $S_2$, $S_3$, $S_4$, $S_5$ sowie der Verlauf der Komparatorausgangsgröße V am Eingang der Steuer- und Zählschaltung SZ über der Zeit dargestellt.

Die Schaltung gemäß Figur 1 arbeitet zunächst einmal nach dem Spannungskompensationsprinzip, indem die Eingangsspannung $U_m$ durch einen Teil $\alpha \cdot U_N$ der Normalspannung $U_N$ kompensiert wird, der als arithmetischer Mittelwert nach dem Zeitteilerprinzip durch Takten des Umschalters $S_1$ im Zeitteilertaktverhältnis

$$\alpha_\gamma = \frac{\tau_\gamma}{T} = \frac{n_\gamma}{N} \qquad (3)$$

aus $U_N$ abgeleitet bzw. heruntergeteilt wird.

Die Abgleichbedingung $\overline{U}_D = U_m - \alpha \cdot U_N$ wird hier erfindungsgemäß intermittierend jeweils exakt über eine volle Zeitteilerperiode T als bestimmtes Integral

$$\overline{U}_D = \frac{1}{T} \cdot \int_{t_{E\gamma}}^{t_{E\gamma+T}} U_D \, dt = \frac{1}{T} \cdot \left[ \int_{t_{E\gamma}}^{t_{E\gamma+T}} U_m \, dt - \int_{t_{E\gamma}}^{t_{E\gamma+\tau_\gamma}} U_N \, dt \right] \overset{!}{=} 0 \qquad (4)$$

mittels des Miller-Integrators (R, C, $V_1$) auf Abweichungen $\Delta U_{D\gamma}$ überwacht. Diese stehen am Ende einer jeden Zeitteilerperiode $T_\gamma$ von $t_{E\gamma}$ bis $t_{E\gamma+T}$ als Regelabweichungsspannungssignal

$$\Delta U_{i\gamma} = \frac{1}{RC} \int_{t_{E\gamma}}^{t_{E\gamma+T}} U_D \, dt = \frac{T}{RC} \cdot \Delta U_D \qquad (5)$$

am Ausgang des Verstärkers $V_1$ zur Verfügung.

Gemäß dem dargestellten Ausführungsbeispiel wird ein solches Regelabweichungssignal $\Delta U_i$ anschließend in der Steuer- und Zähleinheit SZ in einen proportionalen Digitalwert $m_\gamma$ umgesetzt und dieser unmittelbar zur Korrektur des Zeitteilertaktverhältnisses

$$\alpha_\gamma = \frac{\tau_\gamma}{T} = \frac{n_\gamma}{N} \cdot \frac{T_c}{T_c} = \frac{n_\gamma}{N} \qquad (6)$$

aus der zurückliegenden $\nu$. Zeitteilerperiode zum Zeitteilertaktverhältnis

$$\alpha_{\gamma+1} = \alpha_\gamma + \Delta\alpha_\gamma = \frac{n_\gamma + m_\gamma}{N} \qquad (7)$$

in der nachfolgenden $(\nu + 1)$. Zeitteilerperiode genutzt.

In der Schaltung nach Figur 1 geschieht dies insbesondere, indem der Integrator durch Ausschalten von $S_2$ und in Abhängigkeit vom Vorzeichen von $U_{i\nu}$ (festgestellt durch den Komparator $V_2$) durch sinngemäßes Einschalten von $S_3$ bzw. $S_4$ gegen Null integriert wird. Wie vom Sägezahnverschlüßler- oder auch vom Dual-Slope-Verfahren her bekannt, werden während dieser Integration über $S_5$ die $m_\nu$ in den Zähler Z eingezählten Taktimpulse $I_c$ aus dem Taktgenerator CL als Integrationsergebnis genutzt.

Der Zählwert $m_\nu$ wird von der mit dem Mikroprozessor $\mu$P realisierten Steuerschaltung SZ erkannt und zur Korrektur des Zeitteilertakts

$$\tau_{\nu+1} = T_\nu + \Delta\tau_\nu = (n_\nu + m_\nu) T_c \qquad (8)$$

in der $(\nu + 1)$. Zeitteilerperiode T verwendet, wobei $T_c$ die Periodendauer eines Taktimpulses $I_c$ darstellt.

Bei richtiger Dimensionierung von $R_A$ und $U_K$ gelingt es auf diese Weise, das Zeitteilertaktverhältnis $\alpha_\nu$ jeweils schon in der folgenden $(\nu + 1)$-ten Zeitteilerperiode T einem beliebig großen Rechtecksprung der Meßspannung nachzuführen.

Dieses Verhalten wird ebenfalls anhand der Diagramme in Figur 2 näher erläutert.

Zum Zeitpunkt $t_\nu = t_0$ ist die dargestellte Schaltung auf den stationären Abgleichwert

$$\alpha_0 = \frac{\tau_0}{T} = \alpha_0 = \frac{U_m}{U_{m_{max}}} = G \Big/ G_{max} \qquad (9)$$

eingeregelt; somit wird das bestimmte Integral der Spannung $U_D$ in der Zeit von $t_0$ bis $t_0 + T$ exakt den Wert $\Delta U_{i0} \overline{=} 0$ ergeben. Diese Integration findet statt, indem die Normalspannung $U_N$ durch Umschalten von $S_1$ von $t_0$ bis $t_0 + \tau_0$ und $U_m$ von $t_0$ bis $t_0 + T$ über $S_2$ an den ersten Eingang des Integrators (Operationsverstärker $V_1$) gelegt wird.

In einer nachfolgenden Abweichungsverschlüsselungsphase $AV_1$, in der die Kompensationsspannung $-U_V$ über $S_4$ und den Widerstand $R_A$ zum Zeitpunkt $t_2$ an den Integrator $V_1$ gelegt wird, wird wegen $\Delta U_{i0} \overline{=} 0$ erkannt, daß der Zählwert $m_1 = 0$ und daher der erste Zeitteilertakt $\tau_1 = \tau_0$ beizubehalten ist.

Zum Zeitpunkt $t_1$ führt die Meßgröße und damit gekoppelt die Eingangsspannung $U_m$ einen Rechtecksprung von $a_0$ auf $a_1$ aus. Da $\tau_1 = \tau_0$ aber noch dem Aussteuerungsfaktor $a_0$ vor dem Rechtecksprung entspricht, wird das Regelabweichungssignal $\Delta U_{i1}$ in der zum Zeitpunkt $t_2$ folgenden Zeitteilerperiode T zum Zeitpunkt $t_4$ einen entsprechend großen Wert aufweisen.

In der nachfolgenden Abweichungsverschlüsselungsphase $AV_2$ von $t_3$ bis $t_4$ wird wieder die Kompensationsspannung $-U_K$ über $S_4$ und $R_A$ an den Integrator gelegt und $\Delta U_{i1}$ in der Zeit $t_{h1} = m_I \cdot T_c$ auf Null herabintegriert und gleichzeitig $m_I$ Taktimpulse $I_c$ in den Zähler Z eingezählt.

Während der Zeit $t_{c1}$ wird im Mikroprozessor $\mu$P $m_I$ zu $n_I$ addiert und so die Einschaltzeit des ersten Zeitteilertaktes

$$\tau_2 = m_2 \cdot T_c = (n_I + m_I) T_c \qquad (10)$$

vorbereitet, die zum Zeitpunkt $t_4$ mit dem Beginn der nachfolgenden Zeitteilerperiode T einsetzt. Diese endet zum Zeitpunkt $t_5$ und erbringt exakt das Regelabweichungssignal $\Delta U_{i2} \overline{=} 0$, sofern der Widerstand $R_A$ und die Kompensationsspannung $U_K$ richtig dimensioniert sind. Daher wird auch der Zählwert $m_2 \overline{=} 0$, und es ist eine Korrektur von $\tau_3$ gegenüber $\tau_2$ nicht erforderlich.

Sollte jedoch in einer Abweichungsverschlüsselungsphase AV ein Empfindlichkeitsfehler, z. B. durch fehlerhafte Dimensionierung von $R_A$ auftreten, so werden die für jeden Regelkreis üblichen Mechanismen wirksam. Zum Zeitpunkt $t_5$ bleibt zwar noch eine kleine Restspannung $\Delta U_{i2rest} \neq 0$ übrig, die jedoch in der folgenden Zeitteilerperiode T vollständig abgebaut wird. Somit haben Empfindlichkeitsfehler bei den Regelkreiskomponenten zwar Rückwirkungen auf die Geschwindigkeit des Einstellverhaltens, nicht aber auf das stationäre Abgleichergebnis der gesamten Schaltung.

Mit dem angegebenen Ausführungsbeispiel ist erreicht, daß die Genauigkeit der neuen Schaltung trotz ihrer hohen Einstellgeschwindigkeit ausschließlich vom Bezugsnormal (hier Normalspannung $U_N$) und der Teilergenauigkeit (Zeitteilertaktverhältnis $\alpha$) des Zeitteilers bestimmt wird und alle analogen Bauelemente somit unkritisch sind.

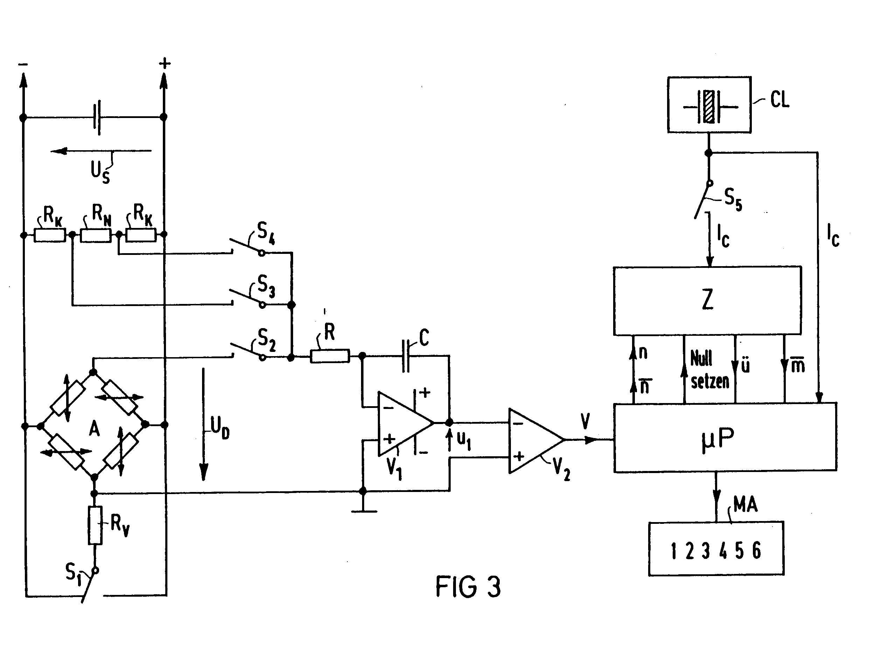

Figur 3 zeigt ein zweites, gegenüber der Figur 1 erweitertes Ausführungsbeispiel mit einem Dehnungsmeßstreifen-Aufnehmer an einer Spannungsversorgung $U_S$, dessen Brückenschaltung A bei meß-

größenabhängigen Verstimmungen durch einen Verstimmungskompensationswiderstand$R_V$, der durch $S_1$ zeitgetaktet wird, kompensiert werden kann. Hier bildet naturgemäß der Widerstand $R_V$ das Bezugsnormal (vgl. Normalspannung $U_N$ aus Figur 1) der Kompensationsschaltung. Die Aufschaltung der Kompensationsgröße (vgl. Kompensationsspannung $+U_K$, $-U_K$ aus Figur 1) während der Abweichungsverschlüsselungsphase AV wird hier mittels eines Spannungsabfalls an Kompensationswiderständen $R_K$ und $R_N$, die parallel zur Spannungsversorgung $U_S$ liegen, durchgeführt.

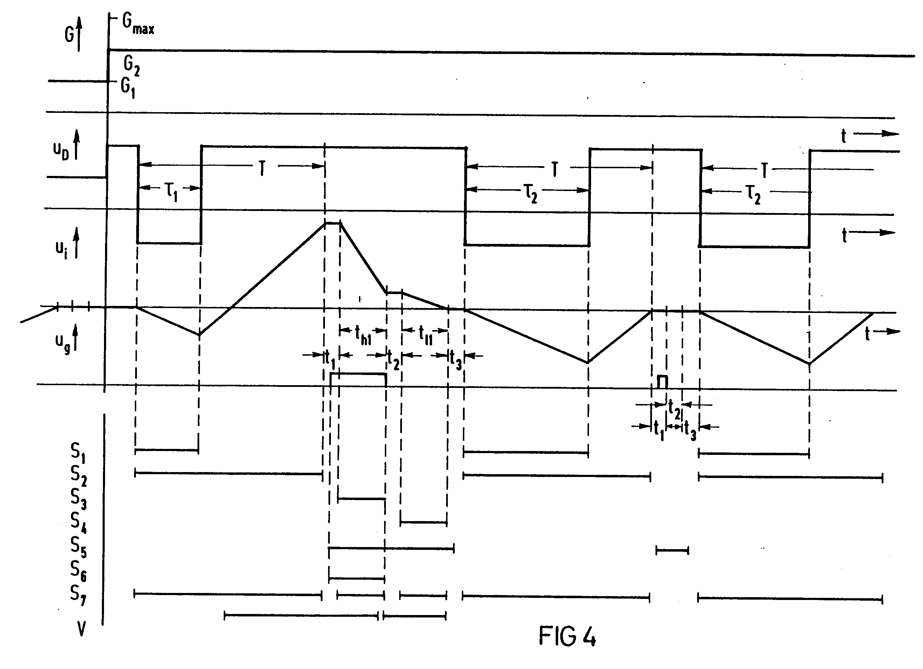

Wie die Diagramme in Figur 4 zeigen, arbeitet die Anordnung ansonsten völlig gleichartig wie die Grundschaltung in Figur 1, lediglich die Aufschaltung der Kompensationsgröße führt zu etwas geänderten Abintegrationsverläufen während der Abweichungsverschlüsselungsphasen AV.

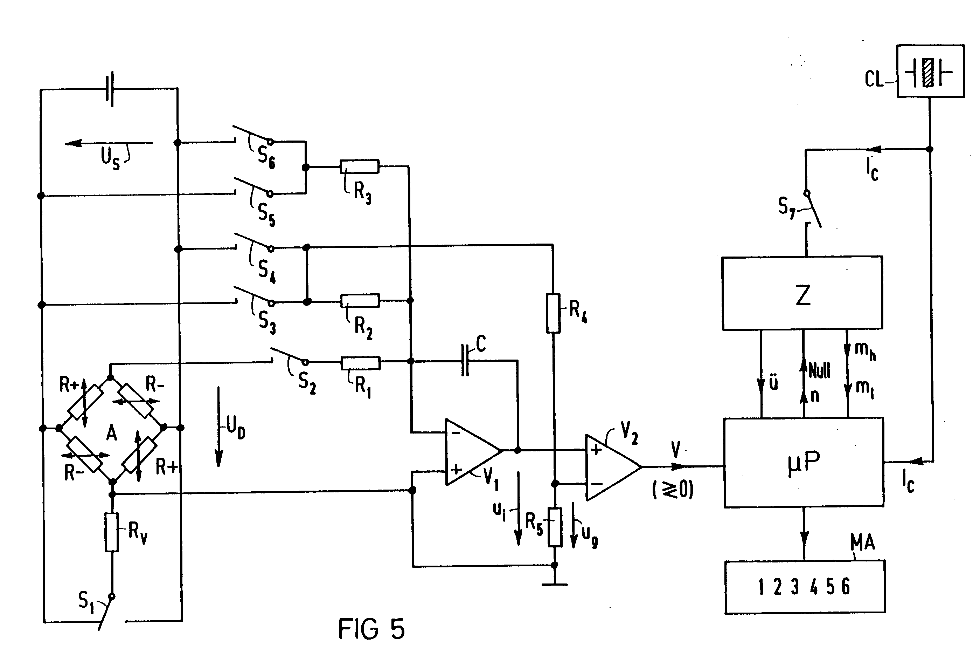

Aus dem dritten Ausführungsbeispiel in der Figur 5 ist eine Weiterentwicklung zu entnehmen, die eine Kaskadierung des Abintegrationsvorganges ermöglicht. Sie wird durch die Verwendung unterschiedlich großer Abintegrationswiderstände $R_2$ und $R_3$ erreicht und gestattet, Regelabweichungsspannungen $\Delta U_{i\nu}$ zunächst mit großer Steilheit abzuintegrieren, bis der über Widerstände $R_4$, $R_5$ vorgespannte Komparator $V_2$ meldet, daß die Korrekturwerte für die oberen Digitalstufen grob erreicht sind. Die verbleibende Restspannung $\Delta U_{i\nu rest}$ kann dann über den sehr viel hochohmigeren Abintegrationswiderstand $R_3$ ($R_3 \gg R_2$) mit kleinerer Integrationssteilheit fein auf Null gebracht werden. Die dazu benötigte Zeit $t_{2\nu}$ dient zur Gewinnung der Werte für die unteren, feinen Digitalstufen.

Die beschriebene Kaskadierung hat den Vorteil, daß trotz sehr hoher Auflösung für die Gewinnung der digitalen Korrekturwerte nur eine sehr kurze (typisch $< 100\ \mu s$) Abintegrationszeit benötigt wird.

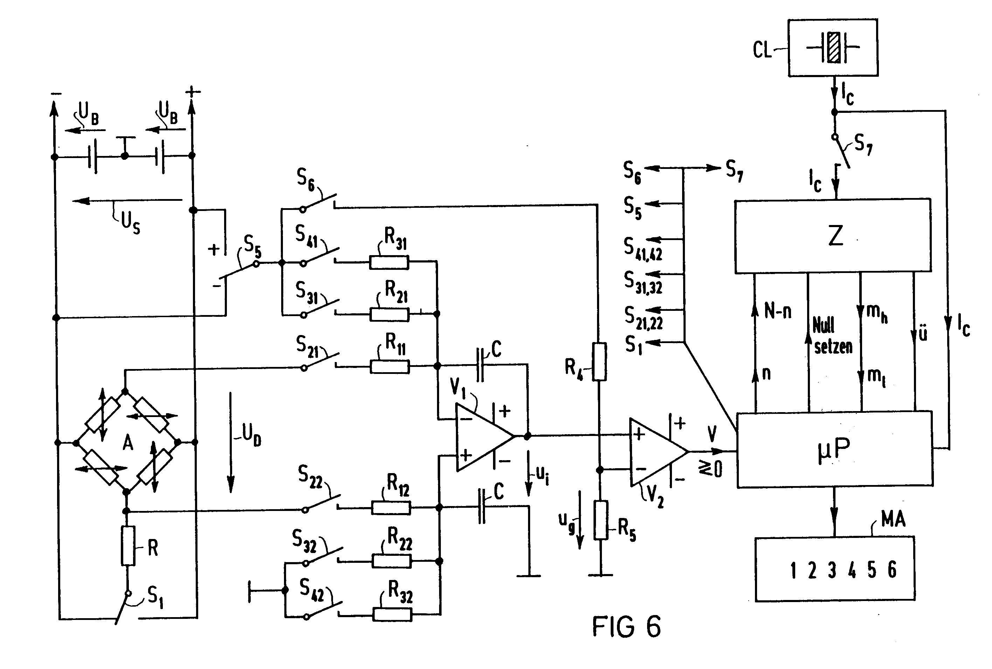

Figur 6 zeigt eine Weiterbildung des Ausführungsbeispiels nach Figur 5, bei der die Aufnehmerbrückenschaltung A erdsymmetrisch betrieben wird, so daß der Integrator (Operationsverstärker $V_1$) zusätzlich eine sehr hohe Gleichtaktunterdrückung bietet. Die Widerstände $R_1$, $R_2$, $R_3$ und Schalter $S_1$, $S_3$, $S_4$ gemäß dem Ausführungsbeispiel nach Figur 5 sind hier somit für jeden Eingang des Operationsverstärkers $V_1$ vorhanden ($R_{11}$, $R_{21}$, $R_{31}$; $R_{12}$, $R_{22}$, $R_{32}$; $S_{21}$, $S_{31}$, $S_{41}$; $S_{22}$, $S_{32}$, $S_{42}$).

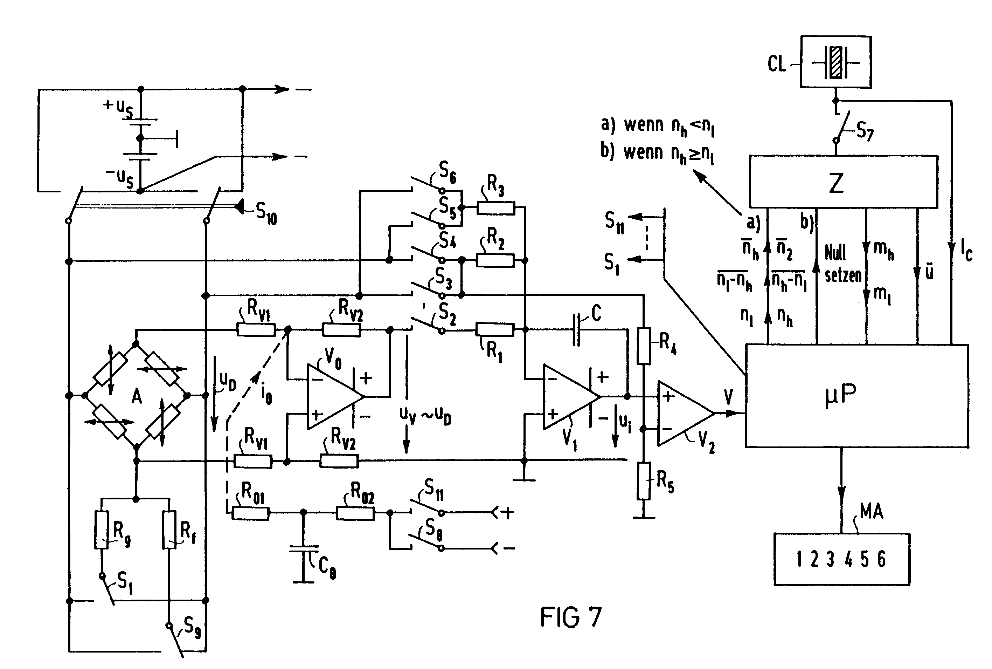

Das Ausführungsbeispiel nach Figur 7 schließt einige aus der DE-PS 33 30 841 bekannte Schaltungsvarianten ein, die vorteilhaft sind, wenn sowohl hohe Unterdrückung von Rauschanteilen, Thermo- und Kontakt-Spannungseinflüssen sowie von Nulldriften der Operationsverstärker erwartet werden. Dies sind zum einen die Kaskadierung der Normalspannung mit Widerständen $R_g$ und $R_f$ als Verstimmungskompensationswiderstände und zum anderen eine getaktete Umpolung der Speisespannung über einen Polumschalter $S_{10}$. Weiterhin ist die zusätzliche Verwendung eines nur sehr gering ausgesteuerten Operationsverstärkers $V_0$ mit einer Beschaltung mit Widerständen $R_{V1}$, $R_{V2}$ vorgesehen, der eine hohe Gleichtaktunterdrückung und Potentialtrennung trotz erdsymmetrischer Speisung $U_S$ ermöglicht.

Zweckmäßig an dieser Schaltung ist, daß jegliche im Hinblick auf denkbare Halbleiterintegrationen problematischen phasenselektiven Gleichrichtungen, analogen Tiefpässe und vorzeichenselektiven Spannungs-Frequenz-Umformer überflüssig werden und deren Aufgaben voll von einer fehlerfrei arbeitenden Digitalelektronik (Mikroprozessor) übernommen werden können, wie sie heute schon in Ein-Chip-Technik in vielen Ausführungsversionen zur Verfügung steht.

Die Schaltungsvariante nach Figur 7 enthält darüber hinaus noch eine effektive Möglichkeit, etwaige Nulldriften des Operationsverstärkers $V_0$ zu unterdrücken, die dieser aus den unterschiedlichen Korrekturwerten nach Größe und Vorzeichen erkennt und die er bei gleichen Meßgrößen in aufeinanderfolgenden, aber mit umgepolten Vorzeichen versorgten Zeitteilerperioden gewinnt. Hier kann dann vorzeichenabhängig über Schalter $S_8$ bzw. $S_{11}$ und einen Widerstand $R_{02}$ ein Kondensator $C_0$ geladen werden, der über einen Widerstand $R_{01}$ einen Driftkompensationsstrom $i_0$ an den Operationsverstärker $V_0$ führt.

Eine solche Stabilisierung des Arbeitspunktes kann sowohl für Integrationszwecke als auch für den Bau sehr hochauflösender Analog-Digital-Umsetzer nach dem vorgestellten Prinzip vorteilhaft sein.

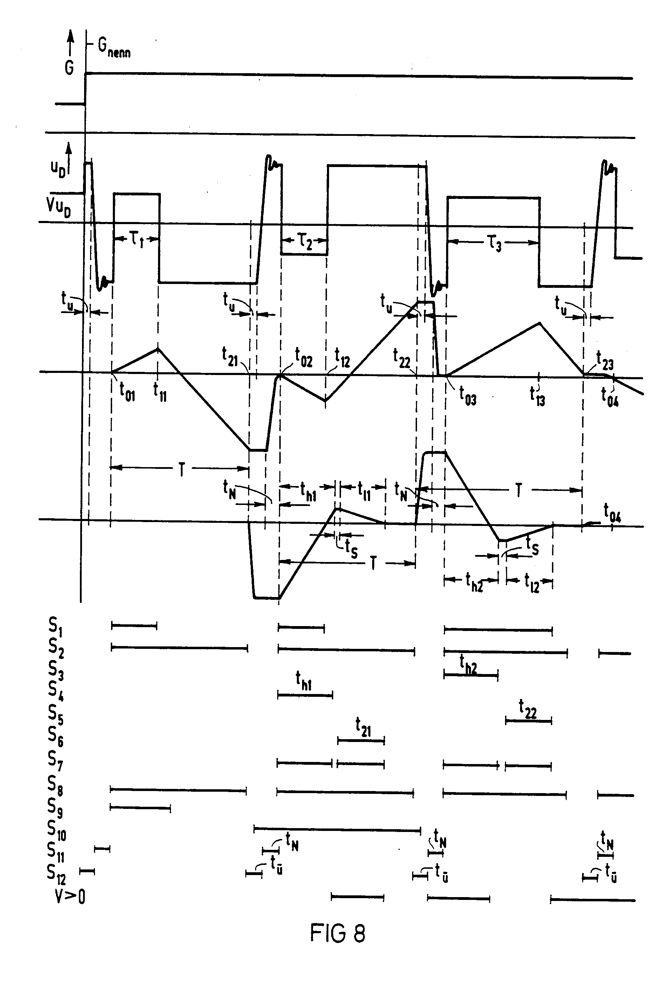

Aus den Signaldiagrammen der Figur 8, die im wesentlichen mit den vorhergehend beschriebenen Signaldiagrammen übereinstimmen, läßt sich zusätzlich noch erkennen, daß es möglich ist, die bisher zeitkritische Umpolung der Versorgungsspannung jetzt problemlos in Zeiten zu legen, in denen keine Zeitteilerintegration stattfindet.

## Patentansprüche

1. Verfahren zur Analog-Digital-Umsetzung eines elektrischen Meßsignals ($U_m$), bei der das Meßsignal ($U_m$) und ein Vergleichssignal ($U_N$) so geschaltet und integriert werden, daß die Summe aus dem Integral des einen Signals ($U_m$ bzw. $U_N$) über einen ersten Zeitabschnitt, einen sogenannten Zeitteilertakt $\tau_\nu$, und aus dem Integral des anderen ($U_N$ bzw. $U_m$) oder beider Signale über einen zweiten Zeitabschnitt gebildet wird, und bei der der Meßwert aus dem Verhältnis, dem sogenannten Zeitteilertaktverhältnis $\alpha_\nu$, des Zeitteilertaktes $\tau_\nu$ zu der Gesamtzeit des ersten und zweiten Zeitabschnitts, der sogenannten Zeitteilerperiode T, gewonnen wird, **dadurch gekennzeichnet,** daß die Summe am Ende der Zeitteilerperiode T als sogenanntes Regelabweichungssignal ($U_i$), das der mittleren Abweichung zwischen Ist- und Sollwert des Zeitteilertaktverhältnisses $\alpha_\nu$ während der Zeitteilerperiode T entspricht, durch Abintegration mit Hilfe eines Kompensationssignals ($-U_k$, $+U_k$) während einer sogenannten Abweichungsverschlüsselungsphase (AV) bestimmt und in ein digitales Regelabweichungssignal mit dem numerischen Wert $m_\nu$ umgewandelt wird und daß das Zeitteilertaktverhältnis $\alpha_{\nu+1}$ während einer unmittelbar nachfolgenden Zeitteilerperiode T gleich

$$\propto_{\gamma+1} \; = \; \frac{n_{\gamma+1}}{N} \; = \; \frac{n_\gamma + m_\gamma}{N}$$

gesetzt wird, wobei $n_\nu$ einen numerischen Wert entsprechend dem Zeitteilertakt $\tau_\nu$, $n_{\nu+1}$ den numerischen Wert entsprechend dem Zeitteilertakt $\tau_{\nu+1}$ der unmittelbar nachfolgenden Zeitteilerperiode und N einen numerischen Wert entsprechend der Länge der Zeitteilerperiode T bezeichnen.

2. Anordnung zur Durchführung des Verfahrens nach Anspruch 1 mit von dem Meßsignal ($U_m$) und dem Vergleichssignal ($U_N$) beaufschlagten Schaltern ($S_1$, $S_2$), die mit den Eingängen eines integrierenden Operationsverstärkers ($V_1$) verbunden sind, und einer Steuer- und Zähleinheit (SZ) zur derartigen Ansteuerung der Schalter ($S_1$, $S_2$), daß diese im Zeitteilertaktverhältnis $\alpha_\nu$ das Meßsignal ($U_m$) während einer ganzen Zeitteilerperiode T und das Vergleichssignal ($U_N$) nur während des Zeitteilertaktes $\tau_\nu$ den Eingängen des integrierenden Operationsverstärkers ($V_1$) zuführen, **dadurch gekennzeichnet**, daß eine Vorrichtung zur Erzeugung einer Kompensationsspannung ($-U_k$, $+U_k$) über Schalter ($S_3$, $S_4$) mit den Eingängen des Operationsverstärkers ($V_1$) verbunden ist und die Steuer- und Zähleinheit (SZ) dazu dient, die Schalter ($S_1$, $S_2$, $S_3$, $S_4$) so zu steuern, daß während der Abweichungsverschlüsselungsphase (AV) das digitale Regelabweichungssignal durch Abintegration mittels der Kompensationsspannung ($-U_k$, $+U_k$) und Zählen von Taktimpulsen ($I_c$) bestimmt und das Zeitteilertaktverhältnis $\alpha_{\nu+1}$ für die nachfolgende Zeitteilerperiode T gemäß dem Verfahren nach Anspruch 1 festgesetzt wird.

3. Anordnung nach Anspruch 2, **dadurch gekennzeichnet,** daß
   - die Steuer- und Zähleinheit (SZ) einen Mikroprozessor ($\mu$P) aufweist, der Taktimpulse ($I_c$) von einem Taktgenerator (CL) erhält und mit einem setzbaren Zähler (Z) und einer Anzeigeeinheit (MA) verbunden ist.

4. Anordnung nach Anspruch 2 oder 3, **dadurch gekennzeichnet,** daß
   - in aufeinanderfolgenden Zeitteilerperioden (T) der Integrator (Verstärker ($V_1$)) jeweils mit umgekehrter Polung der Speisespannung ($U_S$) betrieben
   - und die bei der bestimmten Integration gewonnenen analogen Regelabweichungssignale ($\Delta U_{i\nu}$) bzw. deren zugehörigen Digitalwerte ($m_\nu$) jeweils auch mit umgekehrtem Vorzeichen zur Korrektur des Zeitteilertaktverhältnisses ($\alpha_{\nu+1}$ bzw. $\alpha_{\nu+2}$) herangezogen werden.

5. Anordnung nach einem der Ansprüche 2 bis 4, **dadurch gekennzeichnet,** daß
   - der Mikroprozessor ($\mu$P) einen digitalen Tiefpaß enthält zur digitalen Ausfilterung von dynamischen Störkomponenten, Nulldriften und Rauschanteilen der nach jeder Zeitteilerperiode (T) anfallenden Meßwerte.

6. Anordnung nach einem der Ansprüche 2 bis 5,
   - bei der ein Meßgrößenaufnehmer zur Erzeugung der elektrischen Meßgröße aus ohmschen Fühlerwiderständen in einer Brückenschaltung (A) aufgebaut ist und die Verstimmungsgröße durch Zuschalten eines Verstimmungswiderstandes ($R_V$) in einen Brückenzweig erfolgt und bei der
   - der Meßgrößenaufnehmer und der Verstimmungswiderstand ($R_V$) über einen von der Steuer- und Zähleinheit (SZ) gesteuerten Polumschalter ($S_{10}$) aus einer Gleichstrom- oder Gleichspannungsquelle ($U_S$) gespeist sind,
   **dadurch gekennzeichnet,** daß
   - die Steuer- und Zähleinheit (SZ) den Polumschalter ($S_{10}$) steuert und daß
   - die angelieferten digitalen Regelabweichungssignale (m) im Mikroprozessor ($\mu$P) entsprechend

8

der alternierenden Polung der Speisespannung ($U_S$) mit synchron wechselndem Vorzeichen bewertet sind.

7. Anordnung nach Anspruch 6, **dadurch gekennzeichnet,** daß
   - Vorzeichen und Betrag einer Nulldrift vom Mikroprozessor ($\mu$P) aus dem Vergleich einer größeren Anzahl aufeinanderfolgender Abweichungskorrekturwerte als Mittelwert errechnet und über einen Digital-Analog-Umsetzer ($S_8$, $S_{11}$, $R_{02}$, $C_0$, $R_{01}$) zur Aufschaltung einer Nulldriftkompensation auf einen Eingang des Nullverstärkers ($V_0$) genutzt werden.

8. Anwendung des Verfahrens nach Anspruch 1 oder der Anordnung nach Anspruch 2 bis Anspruch 4,
   - bei der die Meßgröße in einer elektromechanischen Waage erzeugt wird, bei der durch Gewichtsbelastung eine Verstimmung von in Brückenschaltung (A) angeordneten Dehnungsmeßstreifen erzeugt wird und
   - das anzuzeigende Gewicht aus dem Zeitteilertaktverhältnis ($\alpha$) abgeleitet wird.

**Claims**

1. Method for analog-to-digital conversion of an electrical measurement signal ($U_m$) in which the measurement signal ($U_m$) and a comparison signal ($U_N$) are switched and integrated in such a way that the sum of the integral of the one signal ($U_m$ or $U_N$ respectively) over a first time segment, a so-called time divider cycle $\tau_\nu$, and of the integral of the other ($U_N$ or $U_m$ respectively) or both signals over a second time segment is formed and in which the measured value is obtained from the ratio, the so-called time divider timing ratio $\alpha_\nu$, of the time divider cycle $\tau_\nu$ to the total time of the first and second time segment, the so-called time divider period T, characterised in that at the end of the time divider period T by down-slope integration with the aid of a compensation signal ($-U_k, +U_k$) during a so-called deviation encoding phase (AV) the sum is determined as a so-called control deviation signal ($U_i$), which corresponds to the mean deviation between actual and target value of the time divider timing ratio $\alpha_\nu$ during the time divider period T, and is converted into a digital control deviation signal with the numerical value $m_\nu$ and in that the time divider timing ratio $\alpha_{\nu+1}$ is set during an immediately following time divider period T so as to be equal to

$$\alpha_{\gamma+1} = \frac{n_{\gamma+1}}{N} = \frac{n_\gamma + m_\gamma}{N}$$

where $n_\nu$ denotes a numerical value corresponding to the time divider cycle $\tau_\nu$, $n_{\nu+1}$ the numerical value corresponding to the time divider cycle $\tau_{\nu+1}$ of the immediately following time divider period and N a numerical value corresponding to the length of the time divider period T.

2. Arrangement for carrying out the method according to claim 1 having switches ($S_1$, $S_2$), to which the measurement signal ($U_m$) and the comparison signal ($U_N$) are applied and which are connected to the inputs of an integrating operational amplifier ($V_1$), and a control and counting unit (SZ) for such activation of the switches ($S_1$, $S_2$) that the latter in the time divider timing ratio $\alpha_\nu$ supply the measurement signal ($U_m$) during a whole time divider period T and the comparison signal ($U_N$) only during the time divider cycle $\tau_\nu$ to the inputs of the integrating operational amplifier ($V_1$), characterised in that an arrangement for generating a compensation voltage ($-U_k$, $+U_k$) is connected by way of switches ($S_3$, $S_4$) to the inputs of the operational amplifier ($V_1$) and the control and counting unit (SZ) is used to control the switches ($S_1$, $S_2$, $S_3$ $S_4$) in such a way that during the deviation encoding phase (AV) the digital control deviation signal is determined by down-slope integration by means of the compensation voltage ($-U_k$, $+U_k$) and counting of clock pulses ($I_c$) and the time divider timing ratio $\alpha_{\nu+1}$ for the following time divider period T is fixed according to the method of claim 1.

3. Arrangement according to claim 2, characterised in that the control and counting unit (SZ) has a microprocessor ($\mu$P) which obtains clock pulses ($I_c$) from a clock generator (CL) and is connected to a counter (Z), which can be set, and a display unit (MA).

4. Arrangement according to claim 2 or 3,
   characterised in that
   - in successive time divider periods (T) the integrator (amplifier ($V_1$)) is operated in each case with reversed polarity of the supply voltage ($U_S$)
   - and the analog control deviation signals ($\Delta U_{i_\nu}$) obtained in the definite integration or their associated digital values ($m_\nu$) are also used in each case with reversed sign for the correction of the time divider timing ratio ($\alpha_{\nu+1}$ and $\alpha_{\nu+2}$).

5. Arrangement according to one of the claims 2 to 4, characterised in that
   - the microprocessor ($\mu$P) contains a digital low-pass filter for digitally filtering out dynamic interference components, zero drifts and noise components of the measured values obtained after each time divider period (T).

6. Arrangement according to one of the claims 2 to 5,
   - in which a measured variable pick-up is set up for generating the electrical measured variable out of ohmic sensor resistors in a bridge circuit arrangement (A) and the detuning variable is effected by connecting a detuning resistor ($R_V$) into a bridge branch and in which
   - the measured variable pick-up and the detuning resistor ($R_V$) are fed, by way of a pole changing switch ($S_{10}$) controlled by the control and counting unit (SZ), from a direct current or direct voltage source ($U_S$),
   characterised in that
   - the control and counting unit (SZ) controls the pole changing switch ($S_{10}$) and in that
   - the delivered digital control deviation signals (m) are evaluated in the microprocessor ($\mu$P) in accordance with the alternating polarity of the supply voltage ($U_S$) with sign changing in synchronism.

7. Arrangement according to claim 6,
   characterised in that
   - sign and magnitude of a zero drift are calculated by the microprocessor ($\mu$P) as a mean value from the comparison of a comparatively large number of successive deviation correction values and used by way of a digital-to-analog converter ($S_8$, $S_{11}$, $R_{02}$, $C_0$, $R_{01}$) for applying a zero drift compensation to an input of the zero amplifier ($V_0$).

8. Use of the method according to claim 1 or the arrangement according to claim 2 to claim 4,
   - in which the measured variable is generated in an electromechanical balance in which a detuning of strain gauges arranged in bridge circuit arrangement (A) is generated by weight loading and
   - the weight to be displayed is derived from the time divider timing ratio ($\alpha$).

**Revendications**

1. Procédé de conversion analogique/numérique d'un signal de mesure électrique ($U_m$), selon lequel le signal de mesure ($U_m$) et un signal de comparaison ($U_N$) sont commutés et intégrés de telle sorte que la somme de l'intégrale d'un signal ($U_m$ ou $U_N$) pendant un premier intervalle de temps, ce qu'on appelle une cadence de division temporelle $\tau_\nu$, et de l'intégrale de l'autre signal ($U_N$ ou $U_m$) ou des deux signaux pendant un second intervalle de temps, est formée et selon lequel la valeur de mesure est obtenue à partir du rapport, ce qu'on appelle le rapport des cadences de division temporelle $\alpha_\nu$, de la cadence de division temporelle $\tau_\nu$ à la durée totale des premier et second intervalles de temps, ce qu'on appelle la période de division temporelle T, caractérisé par le fait que la somme obtenue à la fin de la période de division temporelle T est déterminée pour constituer ce qu'on appelle un signal d'écart de régulation ($U_i$), qui correspond à l'écart moyen entre la valeur réelle et la valeur de consigne du rapport $\alpha_\nu$ des cadences de division temporelle pendant la période de division temporelle T, par intégration à l'aide d'un signal de compensation ($-U_k$, $+U_k$) pendant ce qu'on appelle une phase de codage d'écart (AV) et est converti en un signal numérique d'écart de régulation avec la valeur numérique $m_\nu$ et que le rapport $\alpha_{\nu+1}$ des cadences de division temporelle est réglé, pendant une période de division temporelle T directement suivante, à une valeur égale à

$$\alpha_{\nu+1} = \frac{n_{\nu+1}}{N} = \frac{n_\nu + m_\nu}{N}$$

$n_\nu$ représentant une valeur numérique correspondant à la cadence de division temporelle $\tau_\nu$, $n_{\nu+1}$ représentant la valeur numérique correspondant à la cadence de division temporelle $\tau_{\nu+1}$ de la période de division temporelle immédiatement suivante et N une valeur numérique correspondant à la durée de la période de division temporelle T.

2.  Dispositif pour la mise en oeuvre du procédé suivant la revendication 1, comportant des commutateurs ($S_1$,$S_2$), qui sont chargés par le signal de mesure ($U_m$) et le signal de comparaison ($U_M$) et sont raccordés aux entrées d'un amplificateur opérationnel intégrateur ($V_1$) et une unité de commande et de comptage (SZ) servant à commander les commutateurs ($S_1$,$S_2$) de telle sorte que ces derniers délivrent, avec le rapport $\alpha_\nu$ des cadences de division temporelle, le signal de mesure ($U_m$) pendant une période complète de division temporelle (T) et le signal de comparaison ($U_N$) uniquement pendant la cadence de division temporelle $\tau_\nu$, aux entrées de l'amplificateur opérationnel intégrateur ($V_1$), caractérisé par le fait qu'un dispositif servant à produire une tension de compensation ($-U_k$, $+U_k$) est raccordé par l'intermédiaire d'interrupteurs ($S_3$, $S_4$) aux entrées de l'amplificateur opérationnel ($V_1$) et que l'unité de commande et de comptage (SZ) sert à commander les commutateurs/interrupteurs ($S_1$, $S_2$, $S_3$, $S_4$) de manière que pendant la phase de codage d'écarts (AV), le signal numérique d'écart de régulation est déterminé par intégration au moyen de la tension de compensation ($-U_k$, $+U_k$) et comptage d'impulsions de cadence ($I_c$) et que le rapport $\alpha_{\nu+1}$ des cadences de division temporelle est fixé pour la période de division temporelle suivante (T), conformément au procédé suivant la revendication 1.

3.  Dispositif suivant la revendication 2, caractérisé par le fait que
    - l'unité de commande et de comptage (SZ) comporte un microprocesseur $\nu$A, qui reçoit des impulsions de cadence ($I_c$) de la part d'un générateur de cadence (CL) et est raccordée à un compteur (Z) pouvant être positionné et à une unité d'affichage (MA).

4.  Dispositif suivant la revendication 2 ou 3, caractérisé par le fait que
    - pendant des périodes successives de division temporelle (T), l'intégrateur (amplificateur ($V_1$)) fonctionne respectivement avec une polarité inverse de la tension d'alimentation ($U_S$), et
    - les signaux analogiques d'écart de réglage ($\Delta U_{i\nu}$), obtenus lors de l'intégration déterminée, ou les valeurs numériques ($m_\nu$), qui leur sont associées, sont respectivement utilisés également avec un signe inversé pour corriger le rapport ($\alpha_{\nu+1}$ ou $\alpha_{\nu+1}$) des cadences de division temporelle.

5.  Dispositif suivant l'une des revendications 2 à 4, caractérisé par le fait que
    - le microprocesseur ($\mu$P) comporte un filtre passe-bas numérique pour réaliser l'élimination par filtrage numérique de composantes parasites dynamiques, de dérives du zéro et de composantes de bruit des valeurs de mesure qui arrivent après chaque période de division temporelle (T).

6.  Dispositif suivant l'une des revendications 2 à 5, dans lequel
    - un enregistreur de grandeurs de mesure servant à produire la grandeur de mesure électrique est constitué par des résistances ohmiques de détection situées dans un montage en pont (A) et que la grandeur de désaccord est obtenue par raccordement supplémentaire d'une résistance de désaccord ($R_V$) dans une branche du pont, et dans lequel
    - l'enregistreur de grandeur de mesure et la résistance de désaccord ($R_V$) sont alimentés à partir d'une source de courant constant ou de tension constante ($U_S$), par l'intermédiaire d'un inverseur de polarité ($S_{10}$) commandé par l'unité de commande et de comptage (SZ),
    caractérisé par le fait que
    - l'unité de commande et de comptage (SZ) commande l'inverseur de polarité ($S_{10}$), et que
    - les signaux numériques d'écart de régulation (m) délivrés sont évalués dans le microprocesseur ($\mu$P) en fonction de la polarité alternée de la tension d'alimentation ($U_S$) avec un signe alterné de façon synchrone.

**7.** Dispositif suivant la revendication 6, caractérisé par le fait
- que le signe et la valeur absolue d'une dérive du zéro sont calculés en tant que valeur moyenne par le microprocesseur ($\mu$P) à partir de la comparaison d'un nombre assez élevé de valeurs successives de correction d'écart et sont utilisés, par l'intermédiaire d'un convertisseur numérique/analogique ($S_8$,$S_{11}$,$R_{02}$,$C_0$,$R_{01}$) pour appliquer une compensation de dérive du zéro à une entrée de l'amplificateur de zéro ($V_0$).

**8.** Application du procédé suivant la revendication 1 ou du dispositif suivant les revendications 2 à 4, dans laquelle
- la grandeur de mesure est produite dans une bascule électromécanique, dans laquelle un désaccord de jauges extensométriques disposées dans le montage en pont (A) est produit au moyen d'une charge réalisée à l'aide d'un poids et
- le poids, qui doit être affiché, est obtenu à partir du rapport ($\alpha$) des cadences de division temporelle.

EP 0 356 438 B1

FIG 1

FIG 2

FIG 3

FIG 4

EP 0 356 438 B1

FIG 5

EP 0 356 438 B1

FIG 6

FIG 7

a) wenn $n_h < n_l$
b) wenn $n_h \geq n_l$

FIG 8